# EUROPEAN PATENT SPECIFICATION

(11) **EP 2 717 316 B1**
(45) Date of publication and mention of the grant of the patent: **14.08.2019**
(21) Application number: 12187332.7
(22) Date of filing: 05.10.2012
(51) Int. Cl.: H01L 29/66

(54) **Method for producing strained germanium fin structures**
Verfahren zur Herstellung verspannter Germanium-Lamellenstrukturen
Procédé de production de structures à ailettes contraintes de germanium

(43) Date of publication of application: 09.04.2014
(73) Proprietor: IMEC VZW, 3001 Leuven (BE)
(72) Inventor: Vincent, Benjamin, 3001 Leuven (BE)
(74) Representative: Patent Department IMEC

(56) References cited:
- WO-A1-2008/039495
- WO-A2-2007/112066
- DE-A1-102007 007 261
- US-A1- 2007 221 956
- US-A1- 2009 085 027
- US-A1- 2010 025 683
- US-A1- 2011 147 811
- US-A1- 2011 180 847
- LIOW TSUNG-YANG ET AL: "Investigation of silicon-germanium fins fabricated using germanium condensation on vertical compliant structures", APPLIED PHYSICS LETTERS, AIP, AMERICAN INSTITUTE OF PHYSICS, MELVILLE, NY, US, vol. 87, no. 26, 19 December 2005 (2005-12-19), pages 262104-262104, XP012077069, ISSN: 0003-6951, DOI: 10.1063/1.2151257
- ROSENBLAD C ET AL: "A plasma process for ultrafast deposition of SiGe graded buffer layers", APPLIED PHYSICS LETTERS, AIP, AMERICAN INSTITUTE OF PHYSICS, MELVILLE, NY, US, vol. 76, no. 4, 24 January 2000 (2000-01-24), pages 427-429, XP012025727, ISSN: 0003-6951, DOI: 10.1063/1.125776
- LANGDO T A ET AL: "High quality Ge on Si by epitaxial necking", APPLIED PHYSICS LETTERS, AIP, AMERICAN INSTITUTE OF PHYSICS, MELVILLE, NY, US, vol. 76, no. 25, 19 June 2000 (2000-06-19) , pages 3700-3702, XP012025569, ISSN: 0003-6951, DOI: 10.1063/1.126754

## Description

### Field of the Invention

The present invention is related to the production of fin-shaped structures comprising strained Ge on a SiGe buffer, mainly for use as quantum well digital logic transistors.

### State of the art

In the search for high mobility materials in replacement of Si in digital logic structures, much interest has gone to the development of Ge channels, in particular strained Ge, due to the high carrier mobility characteristics of the material. In order to ensure optimum mobility, essentially defect-free Ge is required, which further leads to the need for a defect-free surface onto which the Ge is produced. A known technique for depositing a SiGe layer in a narrow trench is referred to as Aspect Ratio Trapping (ART). This technique allows filling of narrow trenches, e.g. obtained by STI (Shallow Trench Isolation) on a silicon substrate, with a SiGe layer that does not show defects in the top part of the trenches. All defects observed originate on the Si/SiGe interface and become trapped by the STI sidewalls. In 'Fabrication of Low-Defectivity, Compressively strained Ge on Si0.2Ge0.8 Structures using Aspect Ratio Trapping', J.-S. Park et al, Journal of the Electrochemical Society, 156(4)H249-H254 (2009), this technique is used and strained Ge layers are then grown on the thus obtained SiGe structures. Optimization of the quality of the Ge-layer is done by performing a pre-baking step prior to Ge-growth.

A problem with the above-described technique wherein the strained Ge is obtained by epitaxial growth of Ge onto the SiGe in the trenches, is that when filling trenches with a width of less than 20nm, twin defects are formed at a higher level in the trench. This puts a limit on the production of fin structures in this way for fin-widths of less than 20nm.

The document US20070221956 discloses a method for forming germanium-rich fins using oxidation of SiGe fins. In this known method, the SiGe fins are formed by patterning an SiGe layer and the underlying graded SiGe buffer.

### Summary of the invention

The invention is related to a method as disclosed in the appended claims. The method of the invention provides a way of producing fin-structures comprising strained Ge on a SiGe buffer of less than 20nm in width, without the above-described limitation on the size of the fins.

The present invention is related to a method for producing one or more semiconductor fin structures, in particular fins comprising a SiGe buffer portion and a strained Ge top portion. The strained Ge portion is formed by a step of oxidizing SiGe structures extending outwards from an insulation surface, said insulation surface being preferably formed by the top surface of STI oxide regions produced in a Si substrate. The SiGe structures may be grown in the Si substrate by Aspect Ratio Trapping, thereby obtaining a SiGe structure that is relaxed and essentially defect free in a top region. The oxidation step results in the formation of a Ge region and a SiO₂ layer covering the fin. The oxidation is continued until a pure strained Ge top portion is obtained on the SiGe base of the fins. The process can involve the oxidation of separate SiGe structures formed by overgrowth of SiGe into separate mushroom-shaped overgrowth portions. In another embodiment, the SiGe structures are formed after a CMP step and the step of etching the oxide regions in between the structures. According to a further embodiment, the SiGe structures are obtained by patterning a SiGe layer that is sufficiently thick so as to obtain relaxed and defect free SiGe in a top sublayer of said SiGe layer.

The invention is thus in particular related to a method for producing one or more semiconductor fin structures comprising the steps of :
- Producing one or more elongate structures on a substrate, said structures consisting of an alloy of silicon and germanium, a part of said structures extending outwards with respect to the surface of an insulation layer present on said substrate, a top portion of said structures consisting of relaxed and defect free alloy material,
- subjecting said structure(s) to an oxidation step, so as to transform said structure(s) to :
   - one or more fins comprising a base portion formed of said alloy and a top portion formed of germanium in a strained condition, said top portion being formed by condensation of germanium,
   - a layer of silicon oxide covering said fin(s), said oxide layer being formed by oxidation of the silicon,
- removing the part of said layer of silicon oxide extending above said surface of said insulation layer, to thereby produce said one or more fin structures comprising a top portion of germanium in strained condition on a base portion of said alloy material.

In the above method, said oxidation and condensation continue until substantially none of the second material remains in the top portion of the fins, whilst the first material in said top portion remains in a strained condition.

According to an embodiment, the step of producing said one or more elongate structures comprises the steps of :
- Providing or producing a substrate having one or more fin-shaped areas on the surface, with insulation areas filling the spaces between said fin-shaped areas,
- Removing substrate material from said fin-shaped areas, thereby creating trenches between said insulation areas,
- Growing said semiconductor alloy in said trenches by a technique that allows Aspect Ratio Trapping of dislocations in said trenches, thereby obtaining relaxed and defect free semiconductor alloy material in an upper portion of said trenches, as well as in a mushroom-shaped portion overgrowing the upper edges of each of said trenches,
- Optionally, removing a top portion of said insulation areas, resulting in said mushroom-shaped portion and optionally at least part of said relaxed and defect free upper portion extending outwards with respect to the surface of said insulation areas or of the remainder of said insulation areas.

According to another embodiment, the step of producing said one or more elongate structures comprises the steps of :
- Providing or producing a substrate having one or more fin-shaped areas on the surface, with insulation areas filling the spaces between said fin-shaped areas,
- Removing substrate material from said fin-shaped areas, thereby creating trenches between said insulation areas,
- Growing said semiconductor alloy in said trenches by a technique that allows Aspect Ratio Trapping of dislocations in said trenches, thereby obtaining relaxed and essentially defect free semiconductor alloy material in an upper portion of said trenches, as well as in a contiguous area overgrowing the upper edges of said trenches,
- Planarizing the substrate at least to the top level of said insulation areas,
- Removing a top portion of said insulation areas, resulting in at least part of said upper relaxed and defect free portion extending outwards with respect to the surface of the remainder of said insulation areas.

According to still another embodiment, the step of producing said one or more elongate structures comprises the steps of :
- Producing a layer of said alloy on a substrate, said layer being sufficiently thick so that it comprises an upper area that is in a relaxed and defect free condition,
- Etching a plurality of trenches in said layer,
- Filling said trenches with an insulation material, optionally followed by a planarization step, to thereby obtain a substrate having one or more elongate areas of said alloy on the surface, with insulation areas filling the spaces between said elongate areas, thereby obtaining relaxed and essentially defect free semiconductor alloy material in an upper portion of said elongate areas,
- Removing a top portion of said insulation areas, resulting in at least part of said upper relaxed and defect free portion extending outwards with respect to the surface of the remainder of said insulation areas.

Said two different semiconductor materials are silicon and germanium, wherein said compound material is SiGe, said base portion is a SiGe portion and said top portion is a strained Ge portion.

According to an embodiment, SiGe is defined as SiₓGe₁₋ₓ, with x higher than 0.2. Said substrate may be a silicon substrate.

The method of the invention may further comprise the step of depositing a cap layer formed of silicon on said one or more relaxed and defect free fin-shaped structures consisting of said alloy material, before subjecting said structures to said oxidation step.

### Brief description of the figures

Figure 1 illustrates a first embodiment of the method of the invention.
Figure 2 illustrates a second embodiment of the method of the invention.

### Detailed description of the invention

Of a number of terms, the following definitions are valid within the present description as well as in the claims :
- When a volume of a semiconductor or semiconductor alloy, for example SiGe, is said to be 'relaxed' or in 'relaxed condition', this means that the lattice parameter of the material in the volume is equal to the standard equilibrium lattice parameter, in other words there is no strain effect from the substrate on which the volume is produced, having another lattice parameter (smaller in the case of SiGe grown on Si).
- When a volume of semiconductor or a semiconductor alloy is said to be 'strained', this means that said volume is formed of first crystalline material having a first lattice constant, and is overlying a second crystalline material having a second lattice constant different then the first, wherein the crystalline in-plane lattices are matched at the interface between the first and second material, i.e. the first lattice is stretched or compressed to match the second lattice, thereby inducing strain in the first crystalline material.
- A volume of a semiconductor or semiconductor alloy (e.g. Ge or SiGe) is said to be 'defect free' when there are essentially no defects appearing as a consequence of propagating dislocations in the volume.

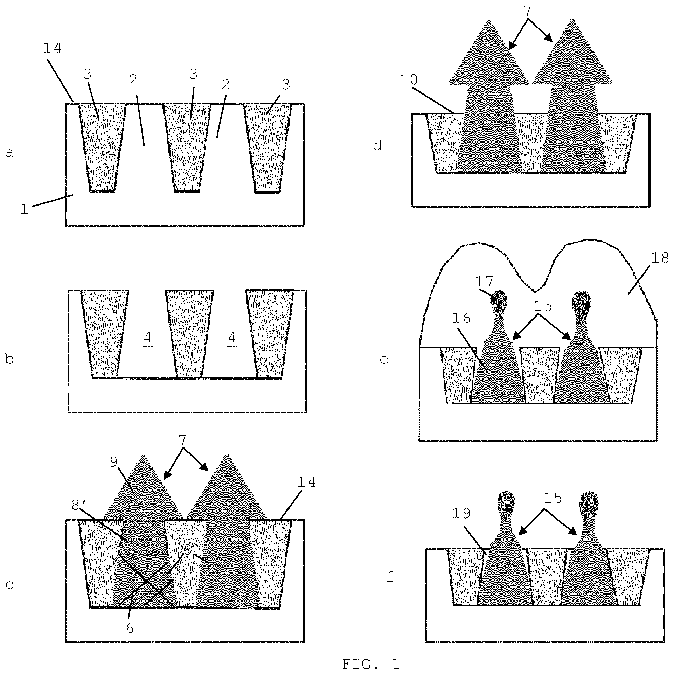

Figures 1a to 1f illustrate a first embodiment of the method according to the invention. On a silicon substrate 1, standard STI (Shallow Trench Isolation) is performed to form silicon fin-shaped structures 2, separated by oxide regions 3, and planarized to a level surface 14. The width of the fin-shaped structures at the top can be about 40nm for example. Then the fin shaped structures 2 are fully or partially removed by an etching step, resulting in a set of trenches 4. These trenches are filled by growing SiGe 5, preferably by the known technique referred to as RPCVD, Reduced Pressure Chemical Vapour Deposition. By 'SiGe' is meant in the present context : the semiconductor alloy SiₓGe₁₋ₓ, with x any suitable value known in the art for this type of alloy. Preferably, x is higher than 0.2, for example x=0.25.

The width and depth of the trenches 4 is such that aspect ratio trapping (ART) takes place, i.e. dislocations 6 become trapped by the sidewalls of the trenches 4. The result is a set of elongate SiGe structures 7, consisting of a base area 8 and a mushroom-shaped overgrowth area 9. The depth and aspect ratio of the trenches 4 is such that in said mushroom-shaped area 9 and in an upper portion 8' of the base area 8, relaxed and defect free SiGe is formed. Optionally, a further etching step removes a portion of the STI oxide, resulting in part of the elongate SiGe structures 7 extending outwards with respect to oxide surface 10 (see figure 1d). When this last etching step is not performed, the mushroom-shaped portion 9 itself is the part that is extending outwards with respect to the oxide surface 14 (see figure 1c). This structure is then subjected to a dry oxidation at high temperature, transforming the structures 7 into :
- fins 15 comprising a SiGe base portion 16 and a top portion 17 of pure strained Ge formed by condensation of Ge,
- a layer 18 of silicon oxide covering said fins 15, formed by oxidation of Si,

The Ge top portion 17 is obtained by condensation of the Ge from the SiGe simultaneously with the oxidation of the Si. The oxidation step (hereafter also referred to as condensation/oxidation step) continues until the top portion 17 of the fins consists of substantially pure strained Ge, i.e. until no silicon is left in the top portion, whilst ensuring that the formed Ge is in a strained condition. To ensure that the Ge is in a strained condition, the condensed volume is kept below the critical volume of plastic relaxation. This critical volume depends on the lattice mismatch between Ge and the initial relaxed SiGe, so mainly on the initial Ge concentration.

Then the silicon oxide layer 18 is removed above the level 10 of the STI regions, by a suitable etching step, resulting in a set of fins 15 having a Ge top portion 17 of defect free strained Ge on a buffer of SiGe (the buffer being the base portion 16). In the regions 19 adjacent to the base portions of the fins, silicon oxide formed in the oxidation step remains, i.e. in the preferred case where the regions 3 are also silicon oxide, the fins are embedded in a continuous oxide layer. A small over-etching may occur of the STI regions 3 during removal of the oxide 18, i.e. material removed from surface 10. The flanks of the base portions 16 may comprise a zone (not shown) of pure Ge or SiGe with higher Ge content, as Ge condensation may take place also in these regions.

The fins 15 are suitable for producing quantum well FinFET transistors by applying further process steps as known in the art. The width of the top portions 17 can be lower than 20nm. The size of this top portion 17 can be designed by adequate choices in terms of the SiGe composition (value of x in SiₓGe₁₋ₓ), the size of the overgrowth areas 9, the size of the trenches 4, taking into account the critical volume as stated above. Sufficient freedom is possible in the choice of these parameters to allow the production of very narrow fin structures starting from trenches 4 that are wide enough to ensure that no twin formation takes place during filling of the trench. The invention thus provides a solution for the above described problem : size reduction of the fins is possible without requiring trenches 4 that are too narrow to avoid twin formation in the upper part of the trench.

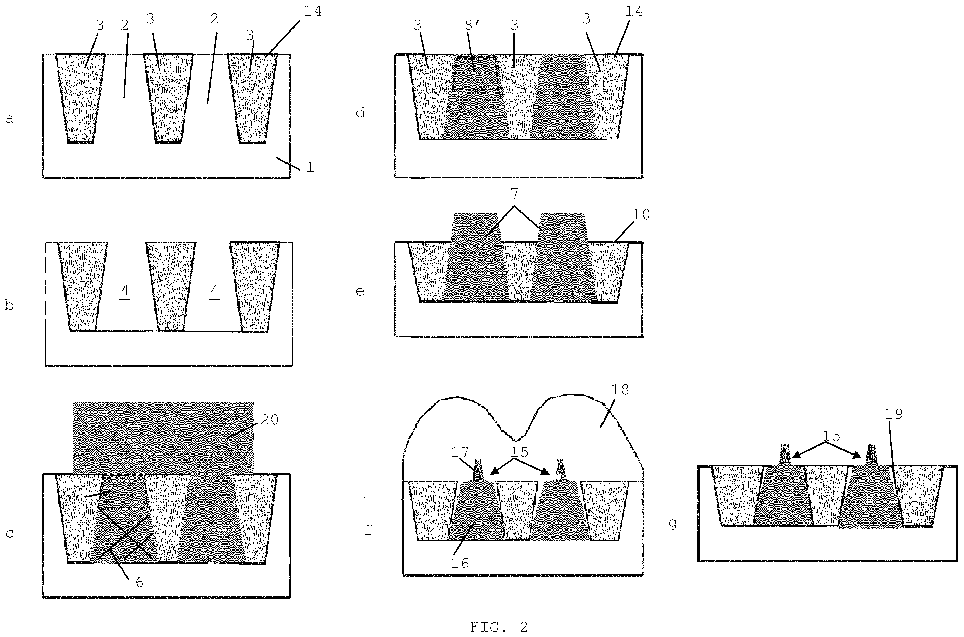

In another embodiment illustrated in figures 2a to 2g, the overgrowth of the SiGe is continued until a contiguous layer 20 of relaxed and defect free SiGe is obtained on top of the STI-substrate. As in the previous embodiment, the depth and aspect ratio of the trenches 4 is such that relaxed and defect free SiGe is obtained in the overgrowth area 20 and in an upper area 8' of the SiGe deposited in the trenches 4. This is followed by a chemical-mechanical-polishing step (CMP) to remove said layer 20 and planarize the substrate at least to the level 14 of the STI substrate, see figure 2d ('at least' meaning that CMP could be continued to a level lower than level 14). An etch step follows to recess the STI oxide regions and form SiGe structures 7, a part of which is extending outwards from the STI surface 10. This structure is then subjected to the oxidation step as described above, again leading to the formation of :
- fins 15 comprising a SiGe base area 16 and a top area 17 of pure strained Ge formed by condensation (taking into account again the critical volume as referred to above),
- a layer 18 of silicon oxide covering said fins 15, formed by oxidation of Si.

After removal of the silicon oxide 18, the strained Ge fins 15 are obtained, with remaining oxide areas 19 at the sides.

According to an embodiment, a thin silicon cap layer is deposited (not shown), preferably by epitaxial growth, on top of the elongate structures 7, before performing the oxidation step. The purpose of this cap layer is to avoid oxidation of Germanium. When the oxidation starts, the Si-cap forms a silicon oxide layer which will obstruct formation of germanium oxide, and ensure that all of the Ge moves to the center portion 17 by condensation. The oxidation of the cap may take place at a lower temperature than the oxidation of the SiGe.

According to an embodiment, diffusion anneal steps can be combined with condensation/oxidation steps in a cyclic process, in order to enhance the interdiffusion of the semiconductor elements in the alloy Si and Ge). This would mean subjecting the wafer to a condensation/oxidation, e.g. at 900°C, during a first timespan, then subjecting it to a diffusion anneal in an inert gas preferably at the same temperature during a second timespan, and repeating the condensation/oxidation and anneal during at least one additional series of a first and second timespans (not necessarily equal to the first series). Such a sequence of condensation/oxidation and anneal cycles is to be regarded as an embodiment of the 'oxidation step' referred to in the claims.

According to another embodiment, the structures 7 that are partly extending outwards with respect to the insulation areas 3 are obtained in another way than in the embodiments of figures 1 and 2. This will again be explained for the case of Si and Ge, though it is applicable also to other materials. According to this embodiment, a layer of SiGe is grown on a substrate, e.g. a Silicon substrate. The layer is grown at a sufficiently high thickness for un upper sublayer of the SiGe to be in a relaxed condition, and defect free. In other words, the thickness is sufficient so that dislocations caused by a mismatch between the SiGe and the underlying substrate do not propagate into said upper portion. In the particular example of SiGe on Si, the SiGe layer is few microns thick, preferably with a Ge gradient in order to bend dislocations defects forming in this way a graded strain relaxed buffer.

Then a patterning and etching step is performed to produce trenches in the SiGe layer, whereafter said trenches are filled with an insulating material, for example silicon oxide. Possibly after a planarization step, this results in the same structure as the one shown in figure 2d, i.e. elongate areas of SiGe in between oxide areas 3, wherein a top portion 8' of the SiGe is relaxed and defect free. The steps shown in figures 2e to 2g and described above in relation to these figures are then performed in the same way.

### Example of process steps (in accordance with the embodiment of figure 1) :

Starting from a Si-wafer having ∼40nm wide fin-shaped Si areas 2 separated by silicon oxide STI regions 3:
1)EPI :
   - load wafer in the EPI tool,
   - Si bake at 850°C to remove native oxide,
   - Remove Si to a depth of ∼300nm at 850°C, by an HCl vapour etch performed in situ in the EPI chamber, to form trenches 4
   - grow SiGe by RPCVD at 20Torr in trenches 4 until forming a mushroom-shaped overgrowth 9 (growing SiGe to a thickness of 400nm in total) at 550°C,
   - grow a 2nm Si cap at 600°C by RPCVD.
2) oxidation process performed in an oxidation furnace :
   - Si cap is first oxidized at 700°C,
   - the rest of the condensation/oxidation process is done afterwards at 900°C during a suitable timespan, ranging from minutes to hours, depending the how much has to be oxidized.
   - removal of SiO₂ by a wet etch such as an HF dip. Preferably a conformal etch is used, i.e. essentially the same thickness of oxide is removed everywhere, so that the oxide in regions 19 remains in place.

While the invention has been illustrated and described in detail in the drawings and foregoing description, such illustration and description are to be considered illustrative or exemplary and not restrictive. The present invention is defined in the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the invention. It will be appreciated, however, that no matter how detailed the foregoing appears in text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated.

Unless specifically specified, the description of a layer being deposited or produced 'on' another layer or substrate, includes the options of
- said layer being produced or deposited directly on, i.e. in contact with, said other layer or substrate, and
- said layer being produced on one or a stack of intermediate layers between said layer and said other layer or substrate.

## Claims

1. A method for producing one or more semiconductor fin structures (15) comprising the steps of :
• Producing one or more elongate structures (7) on a substrate, said structures consisting of an alloy of silicon and germanium, a part of said structures extending outwards with respect to the surface (10,14) of an insulation layer present on said substrate, a top portion (8',9) of said structures consisting of relaxed and defect free alloy material,
• subjecting said structure(s) (7) to an oxidation step, so as to transform said structure(s) to :
• one or more fins (15) comprising a base portion (16) formed of said alloy and a top portion (17) formed of germanium in a strained condition, said top portion being formed by condensation of germanium,
• a layer of silicon oxide (18), covering said fin(s) (15), said oxide layer (18) being formed by oxidation of the silicon,
• removing the part of said layer (18) of silicon oxide extending above said surface (10,14) of said insulation layer, to thereby produce said one or more fin structures (15) comprising a top portion (17) of germanium in strained condition on a base portion (16) of said alloy material.

2. Method according to claim 1, wherein the step of producing said one or more elongate structures (7) comprises the steps of :
• Providing or producing a substrate (1) having one or more fin-shaped areas (2) on the surface, with insulation areas (3) filling the spaces between said fin-shaped areas,
• Removing substrate material from said fin-shaped areas (2), thereby creating trenches (4) between said insulation areas (3),
• Growing said silicon and germanium alloy in said trenches (4) by a technique that allows Aspect Ratio Trapping of dislocations in said trenches, thereby obtaining relaxed and defect free alloy material in an upper portion (8') of said trenches, as well as in a mushroom-shaped portion (9) overgrowing the upper edges of each of said trenches (4),
• Optionally, removing a top portion of said insulation areas (3), resulting in said mushroom-shaped portion (9) and optionally at least part of said relaxed and defect free upper portion (8') extending outwards with respect to the surface (14,10) of said insulation areas (3) or of the remainder of said insulation areas (3).

3. Method according to claim 1, wherein the step of producing said one or more elongate structures (7) comprises the steps of :
• Providing or producing a substrate (1) having one or more fin-shaped areas (2) on the surface, with insulation areas (3) filling the spaces between said fin-shaped areas,
• Removing substrate material from said fin-shaped areas (2), thereby creating trenches (4) between said insulation areas (3),
• Growing said silicon and germanium alloy in said trenches by a technique that allows Aspect Ratio Trapping of dislocations in said trenches, thereby obtaining relaxed and essentially defect free alloy material in an upper portion (8') of said trenches, as well as in a contiguous area (20) overgrowing the upper edges of said trenches,
• Planarizing the substrate at least to the top level (14) of said insulation areas (3),
• Removing a top portion of said insulation areas (3), resulting in at least part of said upper relaxed and defect free portion (8') extending outwards with respect to the surface (10) of the remainder of said insulation areas (3).

4. Method according to claim 1, wherein the step of producing said one or more elongate structures (7) comprises the steps of :
• Producing a layer of said alloy on a substrate, said layer being sufficiently thick so that it comprises an upper area that is in a relaxed and defect free condition,
• Etching a plurality of trenches in said layer,
• Filling said trenches with an insulation material, optionally followed by a planarization step, to thereby obtain a substrate having one or more elongate areas of said alloy on the surface, with insulation areas (3) filling the spaces between said elongate areas, thereby obtaining relaxed and essentially defect free alloy material in an upper portion (8') of said elongate areas,
• Removing a top portion of said insulation areas (3), resulting in at least part of said upper relaxed and defect free portion (8') extending outwards with respect to the surface (10) of the remainder of said insulation areas (3).

5. Method according to claim 4, wherein the silicon and germanium alloy is defined as SiₓGe₁₋ₓ, with x higher than 0.2.

6. Method according to any one of claims 1 to 5, wherein said substrate is a silicon substrate.

7. Method according to any one of claims 1 to 6, further comprising the step of depositing a cap layer formed of the second semiconductor material on said one or more relaxed and defect free fin-shaped structures (7) consisting of said alloy material, before subjecting said structures to said oxidation step.

## Patentansprüche

1. Verfahren zur Herstellung einer oder mehrerer Halbleiterlamellenstrukturen (15), umfassend die Schritte zum:
• Herstellen einer oder mehrerer länglicher Strukturen (7) auf einem Substrat, wobei die Strukturen aus einer Legierung aus Silizium und Germanium bestehen, ein Teil der Strukturen sich in Bezug auf die Oberfläche (10, 14) einer Isolierungsschicht, die auf dem Substrat vorliegt, nach außen erstreckt, ein Deckabschnitt (8',9) der Strukturen aus entspanntem und defektfreiem Legierungsmaterial besteht,
• Unterziehen der Struktur(en) (7) einem Oxidationsschritt, um die Struktur(en) umzuwandeln zu:
• einer oder mehreren Lamellen (15), die einen Basisabschnitt (16) umfassen, der aus der Legierung gebildet ist, und einen Deckabschnitt (17), der aus Germanium in einem verspannten Zustand gebildet ist, wobei der Deckabschnitt durch Kondensation von Germanium gebildet wird,
• eine Schicht aus Siliziumoxid (18), die die Lamelle(n) (15) abdeckt, wobei die Oxidschicht (18) durch Oxidation des Siliziums gebildet wird,
• Entfernen des Teils der Schicht (18) von Siliziumoxid, die sich über der Oberfläche (10, 14) der Isolierungsschicht erstreckt, um dadurch die eine oder mehreren Lamellenstrukturen (15), die einen Deckabschnitt (17) von Germanium in verspanntem Zustand umfasst, auf einem Basisabschnitt (16) des Legierungsmaterials herzustellen.

2. Verfahren nach Anspruch 1, wobei der Schritt zur Herstellung der einen oder mehreren länglichen Strukturen (7) die Schritte umfasst zum:
• Bereitstellen oder Herstellen eines Substrats (1) mit einem oder mehreren lamellenförmigen Bereichen (2) auf der Oberfläche, mit Isolierungsbereichen (3), die die Räume zwischen den lamellenförmigen Bereichen füllen,
• Entfernen von Substratmaterial von den lamellenförmigen Bereichen (2), wodurch Gräben (4) zwischen den Isolierungsbereichen (3) erzeugt werden,
• Züchten der Silizium- und Germaniumlegierung in den Gräben (4) durch eine Technik, die "Aspect Ratio Trapping" von Verlagerungen in den Gräben erlaubt, wodurch entspanntes und defektfreies Legierungsmetall in einem oberen Abschnitt (8') der Gräben erhalten wird, wie auch in einem pilzförmigen Abschnitt (9), der die Oberkanten von jedem der Gräben (4) überspannt,
• optional, Entfernen eines Deckabschnitts der Isolierungsbereiche (3), was dazu führt, dass sich der pilzförmige Abschnitt (9) und optional mindestens Teil des entspannten und defektfreien oberen Abschnitts (8') in Bezug auf die Oberfläche (14, 10) der Isolierungsbereiche (3) oder des Rests der Isolierungsbereiche (3) nach außen erstrecken.

3. Verfahren nach Anspruch 1, wobei der Schritt zum Herstellen der einen oder mehreren länglichen Strukturen (7) die Schritte umfasst zum:
• Bereitstellen oder Herstellen eines Substrats (1) mit einem oder mehreren lamellenförmigen Bereichen (2) auf der Oberfläche, mit Isolierungsbereichen (3), die die Räume zwischen den lamellenförmigen Bereichen füllen,
• Entfernen von Substratmaterial von den lamellenförmigen Bereichen (2), wodurch Gräben (4) zwischen den Isolierungsbereichen (3) gebildet werden,
• Züchten der Silizium- und Germaniumlegierung in den Gräben durch eine Technik, die "Aspect Ratio Trapping" von Verlagerungen in den Gräben erlaubt, wodurch entspanntes und im Wesentlichen defektfreies Legierungsmaterial in einem oberen Abschnitt (8') der Gräben erhalten wird, wie auch in einem angrenzenden Bereich (20), der die oberen Ränder der Gräben überlagert,
• Ebnen des Substrats mindestens bis zur höchsten Ebene (14) der Isolierungsbereiche (3),
• Entfernen eines Deckabschnitts der Isolierungsbereiche (3), was darin resultiert, dass mindestens Teil des oberen entspannten und defektfreien Abschnitts (8') sich in Bezug auf die Oberfläche (10) des Rests der Isolierungsbereiche (3) nach außen erstreckt.

4. Verfahren nach Anspruch 1, wobei der Schritt zur Herstellung der einen oder mehreren länglichen Strukturen (7) die Schritte umfasst zum:
• Herstellen einer Schicht der Legierung auf einem Substrat, wobei die Schicht ausreichend dick ist, sodass sie einen oberen Bereich umfasst, der in einem entspannten und defektfreien Zustand ist,
• Ätzen einer Vielzahl an Gräben in die Schicht,
• Füllen der Gräben mit einem Isolierungsmaterial, optional gefolgt von einem Ebnungsschritt, um dadurch ein Substrat mit einem oder mehreren länglichen Bereichen der Legierung auf der Oberfläche zu erhalten, mit Isolierungsbereichen (3), die die Räume zwischen den länglichen Bereichen füllen, wodurch entspanntes und im Wesentlichen defektfreies Legierungsmaterial in einem oberen Abschnitt (8') der länglichen Bereiche erhalten wird,
• Entfernen eines Deckabschnitts der Isolierungsbereiche (3), was darin resultiert, dass mindestens Teil des oberen entspannten und defektfreien Abschnitts (8'), sich in Bezug auf die Oberfläche (10) des Rests der Isolierungsbereiche (3) nach außen erstreckt.

5. Verfahren nach Anspruch 4, wobei die Silizium- und Germaniumlegierung als SiₓGe₁₋ₓ definiert ist, mit x höher als 0,2.

6. Verfahren nach einem der Ansprüche 1 bis 5, wobei das Substrat ein Siliziumsubstrat ist.

7. Verfahren nach einem der Ansprüche 1 bis 6, weiter umfassend den Schritt zum Abscheiden einer Abdeckschicht, die aus dem zweiten Halbleitermaterial gebildet wird, auf der einen oder den mehreren entspannten und defektfreien lamellenförmigen Strukturen (7), die aus dem Legierungsmaterial bestehen, bevor die Strukturen dem Oxidationsschritt unterzogen werden.

## Revendications

1. Procédé de production d'une ou plusieurs structures d'ailette semiconductrice (15) comprenant les étapes consistant à :
• produire une ou plusieurs structures allongées (7) sur un substrat, lesdites structures étant constituées d'un alliage de silicium et de germanium, une partie desdites structures s'étendant vers l'extérieur par rapport à la surface (10, 14) d'une couche d'isolation présente sur ledit substrat, une partie supérieure (8', 9) desdites structures consistant en un matériau d'alliage relâché et exempt de défaut,
• soumettre ladite ou lesdites structure(s) (7) à une étape d'oxydation, de manière à transformer ladite ou lesdites structure(s) en :
• une ou plusieurs ailettes (15) comprenant une partie de base (16) formée dudit alliage et une partie supérieure (17) formée de germanium dans un état contraint, ladite partie supérieure étant formée par condensation de germanium,
• une couche d'oxyde de silicium (18) recouvrant ladite ou lesdites ailette(s) (15), ladite couche d'oxyde (18) étant formée par oxydation du silicium,
• retirer la partie de ladite couche (18) d'oxyde de silicium s'étendant au-dessus de ladite surface (10, 14) de ladite couche d'isolation, pour produire ainsi lesdites une ou plusieurs structures d'ailette (15) comprenant une partie supérieure (17) de germanium dans un état contraint sur une partie de base (16) dudit matériau d'alliage.

2. Procédé selon la revendication 1, dans lequel l'étape de production desdites une ou plusieurs structures allongées (7) comprend les étapes consistant à :
• fournir ou produire un substrat (1) ayant une ou plusieurs zones en forme d'ailette (2) sur la surface, avec des zones d'isolation (3) remplissant les espaces entre lesdites zones en forme d'ailette,
• retirer le matériau de substrat desdites zones en forme d'ailette (2), en créant ainsi des tranchées (4) entre lesdites zones d'isolation (3),
• faire croître ledit alliage de silicium et de germanium dans lesdites tranchées (4) selon une technique permettant un piégeage de facteur de forme de dislocations dans lesdites tranchées, en obtenant ainsi un matériau d'alliage relâché et sans défaut dans une partie supérieure (8') desdites tranchées, ainsi que dans une partie en forme de champignon (9) recouvrant les bords supérieurs de chacune desdites tranchées (4),
• facultativement, retirer une partie supérieure desdites zones d'isolation (3), en ayant pour résultat partie en forme de champignon (9) et facultativement au moins une partie de ladite partie supérieure relâchée et exempte de défauts (8') s'étendant vers l'extérieur par rapport à la surface (14, 10) desdites zones d'isolation (3) ou du reste desdites zones d'isolation (3).

3. Procédé selon la revendication 1, dans lequel l'étape de production desdites une ou plusieurs structures allongées (7) comprend les étapes consistant à :
• fournir ou produire un substrat (1) ayant une ou plusieurs zones en forme d'ailette (2) sur la surface, avec des zones d'isolation (3) remplissant les espaces entre lesdites zones en forme d'ailette,
• retirer le matériau de substrat desdites zones en forme d'ailette (2), en créant ainsi des tranchées (4) entre lesdites zones d'isolation (3),
• faire croître ledit alliage de silicium et de germanium dans lesdites tranchées selon une technique permettant un piégeage de rapport de forme de dislocations dans lesdites tranchées, en obtenant ainsi un matériau d'alliage relâché et sensiblement exempt de défauts dans une partie supérieure (8') desdites tranchées, ainsi que dans une zone contiguë (20) recouvrant les bords supérieurs desdites tranchées,
• aplanir le substrat au moins jusqu'au niveau supérieur (14) desdites zones d'isolation (3),
• retirer une partie supérieure desdites zones d'isolation (3), de sorte qu'au moins une partie de ladite partie supérieure relâchée et exempte de défaut (8') s'étende vers l'extérieur par rapport à la surface (10) du reste desdites zones d'isolation (3).

4. Procédé selon la revendication 1, dans lequel l'étape de production desdites une ou plusieurs structures allongées (7) comprend les étapes consistant à :
• produire une couche dudit alliage sur un substrat, ladite couche étant suffisamment épaisse pour comprendre une zone supérieure qui est dans un état relâché et exempt de défaut,
• graver une pluralité de tranchées dans ladite couche,
• remplir lesdites tranchées avec un matériau d'isolation, puis facultativement une étape d'aplanissement, pour obtenir ainsi un substrat comportant une ou plusieurs zones allongées dudit alliage à la surface, des zones d'isolation (3) comblant les espaces entre lesdites zones allongées, en obtenant ainsi matériau d'alliage relâché et sensiblement exempt de défauts dans une partie supérieure (8') desdites zones allongées,
• retirer une partie supérieure desdites zones d'isolation (3), en ayant pour résultat qu'au moins une partie de ladite partie supérieure relâchée et exempte de défaut (8') s'étende vers l'extérieur par rapport à la surface (10) du reste desdites zones d'isolation (3).

5. Procédé selon la revendication 4, dans lequel l'alliage de silicium et de germanium est défini en tant que SiₓGe₁₋ₓ, avec x supérieur à 0,2.

6. Procédé selon l'une quelconque des revendications 1 à 5, dans lequel ledit substrat est un substrat de silicium.

7. Procédé selon l'une quelconque des revendications 1 à 6, comprenant en outre l'étape consistant à déposer une couche de recouvrement formée du second matériau semi-conducteur sur lesdites une ou plusieurs structures en forme d'ailette détendues et exempte de défaut (7) constituées dudit matériau d'alliage, avant de soumettre lesdites structures à ladite étape d'oxydation.
